# EUROPÄISCHE PATENTSCHRIFT

(11) **EP 3 994 710 B1**
(45) Veröffentlichungstag und Bekanntmachung des Hinweises auf die Patenterteilung: **18.09.2024**
(21) Anmeldenummer: 20739589.8
(22) Anmeldetag: 03.07.2020
(51) Int. Cl.: H01C 1/14, H01C 1/142, H01C 7/04, H01C 7/18

(54) **NTC-DÜNNSCHICHTTHERMISTOR UND VERFAHREN ZUR HERSTELLUNG EINES NTC-DÜNNSCHICHTTHERMISTORS**
NTC THIN FILM THERMISTOR AND METHOD FOR PRODUCING AN NTC THIN FILM THERMISTOR
THERMISTANCE CTN À COUCHES MINCES ET PROCÉDÉ DE FABRICATION D'UNE THERMISTANCE CTN À COUCHES MINCES

(30) Priorität: 05.07.2019 DE 102019118299
(43) Veröffentlichungstag der Anmeldung: 11.05.2022
(73) Patentinhaber: TDK Electronics AG, 81671 München (DE)
(72) Erfinder: STENDEL, Thomas, 12209 Berlin (DE); IHLE, Jan, 8074 Raaba-Grambach (AT); MEAD, Christl Lisa, 8543 St. Martin i. S. (AT); BERNERT, Thomas, 8530 Deutschlandsberg (AT); REDOLFI, Sebastian, 8010 Graz (AT); VRABELJ, Marko, 9253 Apace (SI)
(74) Vertreter: Epping - Hermann - Fischer
(86) Internationale Anmeldenummer: PCT/EP2020/068864
(87) Internationale Veröffentlichungsnummer: WO 2021/004957

(56) Entgegenhaltungen:
- JP-A- 2000 348 911
- JP-A- 2004 335 731
- JP-A- 2013 197 367
- US-A1- 2004 216 305
- US-A1- 2008 079 118
- US-A1- 2013 258 544
- US-A1- 2013 328 154
- US-A1- 2017 194 419

## Beschreibung

Die Erfindung betrifft einen NTC-Dünnschichtthermistor sowie ein Verfahren zur Herstellung eines NTC-Dünnschichtthermistors.

Auf Grund der Miniaturisierung ist es von hohem Interesse die Größe von elektronischen Bauteilen, Komponenten und Sensoren zur verringern, um so eine möglichst große Anzahl an elektronischen Bauteilen in den Endgeräten unterzubringen und diese leistungsfähiger zu machen. Insbesondere werden eine immer größer werdende Anzahl an Sensoren in den Endgeräten mit dem Ziel eingebaut diese intelligenter und sicherer zu gestalten.

NTC-Thermistoren sind Widerstände mit negativen Temperaturkoeffizienten, die häufig als Sensoren zur Temperaturmessung in elektronischen Geräten eingesetzt werden. In der Patentschrift US 2009/0179732 A1 werden vorteilhafte Keramiken für einen NTC-Thermistor vorgestellt. In den Beispielen werden typische NTC-Thermistoren in einer Mehrschichtbauweise aufgezeigt, bei denen die Keramiken zu Folien verarbeitet werden, die eine Dicke von 20 bis 50 µm haben, und die fertigen mehrschichtigen NTC-Thermistoren eine Ausdehnung von einigen Millimetern in alle drei Raumrichtungen aufweist. Eine solche Größe ist für viele Anwendungen nicht geeignet. Indem deren Abmessung deutlich verkleinert wird, kann nicht nur Platz für andere Bauteile in den Anwendungen geschaffen werden, sondern darüber hinaus vollkommen neue Einsatzmöglichkeiten und Felder erschlossen werden.

In der Patentschrift JP 2000 348911 A wird ein Thermistor vorgestellt, der ein Substrat aus Aluminium und einen darauf angeordneten Thermistor-Dünnfilm aufweist. Der Thermistor-Dünnfilm weist ein Metall der Seltenen Erden und ein Übergangsmetall auf und hat eine Perowskit-Kristallstruktur. Auf der Oberseite des Dünnschichtfilms sind kammförmig ineinandergreifende Elektroden aus Platin angeordnet.

Die Patentschrift US 2013/328154 A1 zeigt einen Thermistor, der ein Metallsubstrat, eine darauf angeordnete keramische Schicht und zwei Elektroden aufweist. Die keramische Schicht weist dabei ein NTC-Keramikmaterial, aufweisend eine Kombination der Übergangsmetalle Mn, Ni, Fe, Ti, Co, Al und/oder Zn auf. Die Elektroden weisen eine Dicke zwischen 0,1 µm und 10 µm auf.

Die Patentschrift US 2004/216305 A1 zeigt ein keramisches Vielschichtbauelement, bei dem es sich um einen NTC-Thermistor handeln kann. Das Vielschichtbauelement weist Innenelektroden und keramische Schichten auf, die eine Dicke von etwa 3 µm haben können.

Aus der JP 2004 335731 A ist ein Aufbau eines organischen NTC-Elements bekannt.

Indem NTC-Thermistoren beispielsweise äußerst dünn gestaltet werden, können sie flexibel und daher mechanisch zerstörungsfrei biegbar sein. Wird darüber hinaus ein NTC-Thermistor mit geringer Ausdehnung realisiert, erniedrigt dies womöglich seine thermische Masse und verbessert somit die Ansprechzeit und die Sensitivität des NTC-Thermistors.

Daher ist es wünschenswert, ein NTC-Thermistor mit einer geringen Dimension in alle Raumrichtungen sowie einen besonders flachen NTC-Thermistor herzustellen.

Aufgabe der vorliegenden Erfindung ist es, einen vorteilhaften NTC-Dünnschichtthermistor sowie ein Verfahren zur Herstellung eines NTC-Dünnschichtthermistors bereitzustellen.

Die vorliegende Aufgabe wird durch den NTC-Dünnschichtthermistor nach Anspruch 1 sowie durch ein Verfahren zur Herstellung eines NTC-Dünnschichtthermistors gemäß dem weiteren unabhängigen Anspruch 19 gelöst. Weitere vorteilhafte Ausführungen, potentielle Anordnungen und mögliche Verfahrensschritte sind den weiteren Ansprüchen zu entnehmen.

Es wird ein NTC-Dünnschichtthermistor beschrieben, der aus mindestens einer ersten Dünnschichtelektrode, mindestens einer NTC-Dünnschicht und mindestens einer zweiten Dünnschichtelektrode besteht. Die Ausbildung der Elektroden sowie der funktionalen NTC-Schicht als Dünnschicht ermöglicht es, einen NTC-Thermistor mit einer äußerst kleinen Ausdehnung, vor allem hinsichtlich der Dicke, zu realisieren. Unter einer Dünnschicht können dabei insbesondere Schichten verstanden werden, die aus festen Stoffen im Mikrometerbereich bestehen. Alternativ oder ergänzend kann unter einer Dünnschicht eine Schicht mit einer Dicke von weniger als 10 µm verstanden werden. Ein NTC-Dünnschichtthermistor nach der vorliegenden Erfindung kann vorzugsweise ausschließlich Dünnschichtelektroden und Dünnschichten und keine andersartigen Schichten aufweisen.

Indem Abmessungen eines NTC-Thermistors deutlich verkleinert werden, kann nicht nur Platz für andere Bauteile in den Anwendungen geschaffen werden, sondern darüber hinaus vollkommen neue Einsatzmöglichkeiten und Felder erschlossen werden. Dadurch, dass NTC-Thermistoren beispielsweise äußerst dünn gestaltet werden, können sie flexibel und daher mechanisch zerstörungsfrei biegbar sein. Wird darüber hinaus ein NTC-Thermistor mit geringer Ausdehnung realisiert, erniedrigt dies seine thermische Masse und kann somit die Ansprechzeit und die Sensitivität eines Sensors, der den NTC-Thermistor aufweist, verbessern.

Die NTC-Dünnschicht weist eine ein- oder polykristalline funktionelle Keramik auf, die eine Spinellstruktur oder eine Perowskitstruktur aufweist. Solche Materialien weisen einen charakteristischen nichtlinearen Temperaturkoeffizienten auf, mit dem eine genaue Temperaturmessung ermöglicht werden kann. Darüber hinaus sind vor allem funktionale Keramiken mit einer Perowskitstruktur für einen Einsatz bei hohen Temperaturen geeignet, da die elektrischen Eigenschaften von Perowskitstrukturen gegenüber Spinellstrukturen bei hohen Temperaturen weniger beeinträchtigt werden.

Die NTC-Dünnschichten können zumindest die Elemente Mn und Ni sowie zumindest eines der Elemente Zn, Fe, Co, Cu, Zr, Y, Cr, Ca, Al aufweisen. Diese Elemente sind geeignet eine funktionelle Keramik mit einer Spinell-, oder Perowskitstruktur auszubilden. Indem die Anteile von den unterschiedlichen Elementen in der funktionellen Keramik verändert werden, kann der B-Wert der NTC-Dünnschicht so angepasst werden, dass die Steigung des Temperaturkoeffizienten in dem für eine Anwendung interessanten Temperaturbereich besonders steil ist und damit eine präzise Temperaturmessung ermöglicht.

Ferner können die Dünnschichtelektroden aus einer leitenden Keramik bestehen. Eine leitende Keramik haftet stärker an einer funktionellen Keramik als alternative Materialien, wie beispielsweise ein Metall. Überdies weist eine Dünnschichtelektrode aus einer leitenden Keramik einen ähnlichen Wärmeausdehnungskoeffizienten auf wie eine funktionelle Keramik, wodurch mechanische Verspannungen im NTC-Dünnschichtthermistor bei Temperaturänderung vermieden werden können.

Alternativ können die Dünnschichtelektroden aus einer oder mehreren Lagen von Metallen wie Cu, Pt, Cr, Ni, Ag, Pd, Au, Ti oder einer Mischung, einer intermetallischen Verbindung sowie einer Legierung dieser Elemente bestehen. Dünnschichtelektroden aus Metall weisen eine hohe elektrische Leitfähigkeit auf, wodurch der NTC-Dünnschichtthermistor einen geringeren elektrischen Anschlusswiderstand aufweisen kann.

In einem nicht unter den Schutzumfang der Ansprüche fallenden Beispiel, welches für das Verständnis der Erfindung nützlich ist, können die erste und zweite Dünnschichtelektrode auf einer Oberfläche der NTC-Dünnschicht angeordnet sein. Somit kann der NTC-Dünnschichtthermistor dünner ausgebildet werden als in einer Ausführungsform in der die NTC-Dünnschicht zwischen der ersten und zweiten Elektrode angeordnet ist. Außerdem verläuft in einer Ausführungsform, in der die Elektroden auf einer Oberfläche angeordnet sind, ein Messstrom entlang der NTC-Dünnschicht und nicht senkrecht zu der Schicht. Da die Ausdehnungen der Oberfläche der funktionalen NTC-Dünnschicht ein Vielfaches der Dicke der NTC-Dünnschicht betragen kann, kann ein solch ausgeführter NTC-Dünnschichtthermistor eine präzisere Messgenauigkeit demonstrieren.

In einem weiteren Beispiel, welches nicht unter den Schutzumfang der Ansprüche fällt, können die erste und zweite Dünnschichtelektrode in einer interdigitalen Kammstruktur auf einer Oberfläche angeordnet sein. Da die Elektroden in einer üblichen Kammstruktur einen äquidistanten Abstand voneinander haben, wirkt bei gegebener Messspannung das gleiche elektrische Feld zwischen den Elektroden. Daher weist der Messstrom eines NTC-Dünnschichtthermistors, der mit Elektroden versehen ist, die eine interdigitale Kammstruktur aufweisen, eine vorteilhafte Linearität bezüglich einer angelegten Messspannung auf.

Erfindungsgemäß weist der NTC-Dünnschichtthermistor mehrere erste und zweite Dünnschichtelektroden auf, wobei jeweils eine NTC-Dünnschicht zwischen den ersten Dünnschichtelektroden und den zweiten Dünnschichtelektroden angeordnet ist. In einer solchen Ausführungsform verläuft der Messstrom senkrecht zur Oberfläche der NTC-Dünnschichten. Daher kann die laterale Ausdehnung des gesamten NTC-Dünnschichtthermistors im Gegensatz zu einem NTC-Dünnschichtthermistor, der erste und zweite Elektrode auf einer Oberfläche der NTC-Dünnschicht aufweist, viel geringer ausfallen. Indem mehrere NTC-Dünnschichten aufeinander gestapelt werden kann zusätzlich die Messgenauigkeit des NTC-Dünnschichtthermistors erhöht werden.

Ferner können die ersten und zweiten Dünnschichtelektroden in einem Bereich, in dem sie gegenüber der NTC-Dünnschicht überhängen, auf einer jeweils darunter liegenden ersten oder zweiten Dünnschichtelektrode, die ebenfalls gegenüber der NTC-Dünnschicht überhängt, aufliegen. Die aufliegende Dünnschichtelektrode kann formangepasst an die darunter liegende Dünnschichtelektrode sein. Durch bereits aufgetragene Dünnschichtelektroden kann die Oberflächenbeschaffenheit bzw. Topografie in den Bereichen, die gegenüber der NTC-Dünnschichtelektrode überhängen, Unebenheiten oder Neigungen aufweisen. Indem die Dünnschichtelektroden formangepasst auf den darunter liegenden Dünnschichtelektroden auffliegt, werden diese Unebenheiten bzw. Neigungen nachvollzogen und die elektrische Kontaktfläche sowie die Adhäsion zwischen benachbarten Dünnschichtelektroden erhöht. Somit ist sichergestellt, dass jede der Dünnschichtelektroden elektrisch kontaktiert wird. Bei Vielschichtbauteilen kann es leicht Schwierigkeiten mit der elektrischen Kontaktierung von inneren Elektrodenschichten geben, insbesondere wenn die Elektrodenschichten am Rand des Vielschichtbauteils bündig mit dem Bauteil abschließen. Bei solchen Vielschichtbauteilen können lediglich die Querschnittsflächen der Elektrodenschichten, die am Rand des Vielschichtbauteils offen liegen, als Kontaktfläche für die weitere elektrische Kontaktierung genutzt werden. Da der Querschnitt der Elektrodenschichten, vor allem auch bei Dünnschichtelektroden, sehr gering ausfallen kann, kann der elektrische Widerstand des Bauteils ungewollt hoch werden, oder es können sogar einzelne Elektrodenschichten elektrisch komplett isoliert bleiben. Indem die Dünnschichtelektroden gegenüber den NTC-Dünnschichten herausragen und formangepasst aufeinander aufliegen, wird eine elektrische Kontaktierung jeder einzelnen Dünnschichtelektrode begünstigt.

Darüber hinaus können die ersten und zweiten Dünnschichtelektroden in einem Bereich, in dem sie gegenüber der NTC-Dünnschicht überhängen, kürzer sein als darunter liegenden ersten oder zweiten Dünnschichtelektroden, die gegenüber der NTC-Dünnschicht überhängen. Infolge einer solchen Ausgestaltung bildet sich eine Treppenform durch die Dünnschichtelektroden aus, die das Bauteil in der Dickenrichtung verjüngt. Jede Dünnschichtelektrode bildet hierbei eine Treppenstufe. Da jede Dünnschichtelektrode eine Kontaktoberfläche, analog zur Treppenstufe, ausbildet, kann jede einzelne Dünnschichtelektrode direkt elektrisch kontaktiert werden. Diese mindert die Gefahr, dass eine im Inneren des NTC-Sensors angeordnete Innenelektrode elektrisch isoliert bleibt und nicht funktionsfähig ist. Die Kontaktoberfläche der einzelnen Dünnschichtelektroden und auch vom gesamten NTC-Sensor kann erhöht werden, indem die Dünnschichtelektroden jeweils noch weiter gegenüber einer darunter liegenden Dünnschichtelektroden verkürzt werden. Somit bleibt eine größere Oberfläche der unter liegenden Dünnschichtelektrode, die als Kontaktoberfläche für eine elektrische Kontaktierung genutzt werden kann. Durch die Erhöhung der Kontaktoberfläche des NTC-Dünnschichtsensors wird der Kontaktwiderstand des Bauteils erniedrigt. Auf Grund der Charakteristik eines NTC-Widerstands, nach dem der Widerstand bei steigender Temperatur sinkt, ist ein geringer Kontaktwiderstand besonders für genaue Messungen in hohen Temperaturbereichen vorteilhaft.

Des Weiteren überhängen erfindungsgemäß die ersten Dünnschichtelektroden auf einer ersten Seite des NTC-Dünnschichtthermistors gegenüber der NTC-Dünnschicht wobei die zweiten NTC-Dünnschichtelektroden auf der ersten Seite gegenüber der NTC-Dünnschicht verkürzt sind, und die zweiten Dünnschichtelektroden Überhängen auf einer zweiten Seite des NTC-Dünnschichtthermistors, die der ersten Seite gegenüberliegt, gegenüber der NTC-Dünnschicht und die ersten Dünnschichtelektroden sind auf der zweiten Seite gegenüber der NTC-Dünnschicht verkürzt.

Infolge einer solchen Ausgestaltung bildet sich auf einer ersten und zweiten Seite des NTC-Dünnschichtthermistors eine Treppenform, die das Bauteil in der Dickenrichtung verjüngt. Indem auf einer der zwei Seiten eine Elektrode gegenüber der NTC-Dünnschicht verlängert ist, überlappen die einzelnen Dünnschichtelektroden an dieser Seite und können so gemeinsam kontaktiert werden. Da die andere Elektrode an dieser Seite verkürzt gegenüber der NTC-Dünnschicht ist, liegt immer eine NTC-Dünnschicht zwischen den Elektroden und verhindert somit einen Kurzschluss zwischen den ersten und zweiten Elektroden. Die an der ersten und zweiten Seite überstehenden Teilbereiche der ersten und zweiten Dünnschichtelektrode können mit einer metallisierten Paste oder einem anderen leitenden Medium verstärkt sein. Auch wenn an den überstehenden Teilbereich der Dünnschichtelektroden mehrere Lagen der Dünnschichtelektroden überlappen, sind die Elektroden in diesen Teilbereichen trotzdem äußerst dünn und fragil ausgebildet. Auf den überlappenden Teilbereich kann beispielsweise eine metallisierte Paste aufgetragen werden, um die Elektroden zu verstärken und eine Kontaktierung der Elektroden zu erleichtern.

Ferner können die NTC-Dünnschichten auf einer dritten und vierten Seite, die senkrecht zur ersten und zweiten Seite sind und sich gegenüberliegen, gegenüber den Dünnschichtelektroden überhängen. Ein Überhang der nichtleitenden NTC-Dünnschicht sorgt dafür dass die ersten und zweiten Dünnschichtelektroden auch in den Randbereichen voneinander abgekapselt sind. Auf diese Weise kann sichergestellt werden, dass trotz des geringen Abstands zueinander erste und zweite Elektroden nicht kurz schließen.

Die NTC-Dünnschichten können in einem Bereich, in dem sie gegenüber den Dünnschichtelektroden überhängen, kürzer sein als darunter liegenden NTC-Dünnschicht. Hierdurch bildet sich an den Seiten, an denen die NTC-Dünnschicht überhängt, ein diagonaler Rand des NTC-Dünnschichtthermistors. Eine pyramidenstumpfförmige Ausgestaltung des NTC-Dünnschichtthermistors bietet einen niedrigen Schwerpunkt, wodurch das Bauteil stabiler aufliegt.

Der NTC-Dünnschichtthermistor kann zusätzlich auf einem Trägermaterial angeordnet sein. Das Trägermaterial kann die mechanische Stabilität des NTC-Dünnschichtthermistors erhöhen. Insbesondere für den Transport und den Einbau des Bauteils ist eine hohe mechanische Stabilität wichtig, um Beschädigungen zu vermeiden. Deswegen kann das Bauteil auf einem Trägermaterial angeordnet sein.

Das Trägermaterial kann bereits als eine erste Elektrode ausgebildet sein. Eine dickere leitende keramische Schicht oder eine stabile Metallschicht können hierzu als Trägermaterial dienen. Somit kann das Bereitstellen eines zusätzlichen Trägermaterials vermieden werden.

In das Trägermaterial kann ein Schaltkreis oder ein mikroelektronisches mechanisches System integriert sein, oder das Trägermaterial kann ein Bestandteil eines elektronischen Bauteils sein. Auf diese Weise kann der NTC-Dünnschichtthermistor integrativ mit einer elektrischen Komponente verbunden und kontaktiert werden. Neben elektrischen Komponenten, die aus Halbleitern wie beispielsweise Silizium bestehen, eignen sich elektrische Komponenten aus Keramiken außerordentlich für eine Integration von einem NTC-Dünnschichtthermistors, da sie einen ähnlichen Wärmeausdehnungskoeffizienten wie der NTC-Dünnschichtthermistor besitzen.

Des Weiteren kann auf dem NTC-Dünnschichtthermistor eine Schutzschicht aufgetragen oder das gesamte Bauteil in einer Schutzschicht eingebettet sein, um das Bauteil vor mechanischen, chemischen und anderen Umwelteinflüssen zu schützen. Als Material für die Schutzschicht können sich Glas, Silikon oder andere Polymere eignen.

Die NTC-Dünnschicht kann in einer vorteilhaften Ausführung dünner als 3 µm sein. Somit ist eine dünne Ausgestaltung des NTC-Dünnschichtthermistors, selbst mit mehreren NTC-Dünnschichten, möglich. Es sei noch darauf hingewiesen, dass die NTC-Dünnschicht dick genug sein muss, um einen Kurzschluss zwischen Elektroden zu vermeiden. Eine Dicke von über 0,01 µm ist daher bei typischen Spannungsbereichen und Materialien ratsam.

In einer weiteren Ausführungsform können die Dünnschichtelektroden dünner als 10 µm sein. Wären die Dünnschichtelektroden sehr viel dicker ausgebildet, könnte eine dünne Ausgestaltung des NTC-Dünnschichtthermistors verhindert werden.

Der gesamte NTC-Dünnschichtthermistor kann dünner als 100 µm sein. Somit ist dafür gesorgt, dass der Vorteil der einzelnen sehr dünnen Dünnschichten sich auf das gesamte Bauteil überträgt, und der gesamte NTC-Dünnschichtthermistor sehr dünn bleibt.

Der NTC-Dünnschichtthermistor kann dafür geeignet sein, in ein Substrat oder eine Leiterplatte integriert zu werden. Substrate und auch Leiterplatten können oft nur eine Dicke von einigen 100 µm aufweisen. Da ein NTC-Dünnschichtthermistor nach der vorliegenden Erfindung dünner sein kann, kann er nicht nur als SMD-Bauteil auf einem Substrat oder ein Leiterplatte montiert werden, sondern auch darin integriert werden.

Eine vorteilhafte Anordnung kann eine Leiterplatte und einen NTC-Dünnschichtthermistor aufweisen, wobei der NTC-Dünnschichtthermistor in der Leiterplatte integriert ist. Folglich kann nicht nur Platz auf der Leiterplatte eingespart werden, der für andere Bauteile genutzt werden kann, sondern die Integration des NTC-Dünnschichtthermistors in die Leiterplatte erweitert gleichzeitig deren Funktionalität.

In einer weiteren vorteilhaften Anordnung können mehrere NTC-Dünnschichtthermistoren in einer Matrix angeordnet sein. Durch die geringe Ausdehnung der NTC-Dünnschichtthermistoren, vor allem auch bezüglich ihrer benötigten Oberfläche, sind die NTC-Dünnschichtthermistoren ausgezeichnet für Sensoranwendungen geeignet, bei denen eine ortsaufgelöste Temperaturmessung durchgeführt werden soll. Hierzu werden mehrere NTC-Dünnschichtthermistoren nebeneinander auf einer Matrix angeordnet.

Ein weiterer Aspekt der vorliegenden Anmeldung betrifft ein Verfahren, wie im Anspruch 19 angegeben wird, zur Herstellung eines NTC-Dünnschichtthermistors. Bei dem NTC-Dünnschichtthermistor kann es sich insbesondere um den vorher beschriebenen NTC-Dünnschichtthermistor handeln.

Das Verfahren umfasst die Schritte:
a) Bereitstellen eines nicht leitenden Trägermaterials;
b) Aufbringen von mindestens einer ersten Dünnschichtelektrode;
c) Aufbringen von mindestens einer NTC-Dünnschicht
d) Aufbringen von mindestens einer zweiten Dünnschichtelektrode.

Ein nicht leitendes Trägermaterial kann als ebene Grundfläche benötigt werden, um die weiteren Schichten darauf zu bilden. Erst nachdem mindestens eine NTC-Dünnschicht und mindestens eine erste und zweite Dünnschichtelektrode fertiggestellt wurden, ist der NTC-Dünnschichtthermistor funktionsfähig.

In dem Trägermaterial kann ein Schaltkreis oder ein mikroelektronisches mechanisches System integriert sein, oder das Trägermaterial kann ein Bestandteil eines elektronischen Bauteils sein. So kann eine elektrische Komponente mit einem NTC-Dünnschichtthermistor aufgewertet werden. Durch die integrative Bauweise kann die elektrische Komponente direkt mit dem NTC-Dünnschichtthermistor verbunden und elektrisch kontaktiert werden. Insbesondere elektrische Komponenten aus Keramiken eignen sich als Trägermaterial, da sie einen ähnlichen Wärmeausdehnungskoeffizienten wie der NTC-Dünnschichtthermistor besitzen und der NTC-Dünnschichtthermistor darauf gut haftet. Elektrische Komponenten, Schaltkreise und mikroelektronische mechanische Systeme, die aus Halbleitern wie beispielsweise Silicium bestehen, können ebenfalls als Trägermaterial genutzt werden. In dem Verfahren können die ersten und zweiten Dünnschichtelektroden auf einer Oberfläche der NTC-Dünnschicht angeordnet sein. Ein NTC-Dünnschichtthermistor nach einem solchen Verfahren kann dünner ausgestaltet werden als in einer Bauweise, in der die NTC-Dünnschicht zwischen der ersten und zweiten Elektrode angeordnet ist. In einer Anordnung in der beide Dünnschichtelektroden auf einer Oberfläche liegen, verläuft der Messstrom entlang der NTC-Dünnschicht und nicht senkrecht durch die Schicht. Auf Grund der lateralen Ausdehnungen des NTC-Dünnschichtthermistors, die ein Vielfaches der Dicke der NTC-Dünnschicht sein kann, kann ein solcher NTC-Dünnschichtthermistor eine präzisere Messgenauigkeit aufzeigen.

Erfindungsgemäß ist jeweils eine NTC-Dünnschicht zwischen den ersten Dünnschichtelektroden und den zweiten Dünnschichtelektroden angeordnet. In einem NTC-Dünnschichtthermistor der nach dem Verfahren der Erfindung ausgebildet worden ist, verläuft der Messstrom senkrecht zur Oberfläche durch die NTC-Dünnschichten. Die laterale Ausdehnung eines solchen NTC-Dünnschichtthermistors beeinflusst im Gegensatz zu einem NTC-Dünnschichtthermistor, der erste und zweite Elektrode auf einer Oberfläche der NTC-Dünnschicht aufweist, die Messgenauigkeit nicht im sehr hohen Maße. Daher kann ein NTC-Dünnschichtthermistor nach diesen Verfahren eine viel geringere Ausdehnung aufweisen. Darüber hinaus können die NTC-Dünnschichten aufeinander gestapelt werden um die Messgenauigkeit des NTC-Dünnschichtthermistors zu verbessern.

Das Verfahren kann auch so ausgeführt werden, dass im Schritt b) die ersten Dünnschichtelektroden auch in einen ersten Bereich aufgebracht werden, in dem keine NTC-Dünnschicht darunter liegt, und dass im Schritt d) die zweiten Dünnschichtelektroden auch in einen zweiten Bereich aufgebracht werden, in dem keine NTC-Dünnschicht darunter liegt, wobei der erste und zweite Bereich nicht miteinander überlappen und das Verfahren eine Schrittfolge enthält, in der erst eine erste Dünnschichtelektrodenschicht aufgetragen wird, folgend eine NTC-Dünnschicht aufgetragen wird, dann eine zweite Dünnschichtelektrode aufgetragen wird, worauf wieder eine NTC-Dünnschicht aufgetragen, und im Anschluss wieder eine erste Dünnschichtelektrode aufgetragen wird.

Somit liegen der Dünnschichtelektroden in den zwei Bereichen, in denen sie gegenüber der NTC-Dünnschicht überhängen, formangepasst auf einer jeweils darunter liegenden ersten oder zweiten Dünnschichtelektroden. Ein NTC-Dünnschichtthermistor, der auf Basis dieses Verfahrens hergestellt worden ist, hat den Vorteil, dass die Dünnschichtelektroden, die im Inneren des NTC-Dünnschichtthermistors angeordnet sind, zuverlässiger elektrisch kontaktiert werden und das gesamte Bauteil dadurch robuster wird.

Zusätzlich können im Schritt b) und d), die Dünnschichtelektroden in den zwei Bereichen auch jeweils auch kürzer aufgebracht werden als die darunter liegenden ersten oder zweiten Dünnschichtelektroden. Auf diese Weise bildet sich im ersten und zweiten Bereich jeweils eine Treppenform aus, wobei die einzelnen Treppenstufen aus den Dünnschichtelektroden gebildet werden. Je nachdem, wie stark die Dünnschichtelektrode gegenüber der darunter liegenden Dünnschichtelektrode verkürzt wurde, kann die Kontaktfläche der Dünnschichtelektroden vergrößert und damit der Kontaktwiderstand verringert werden. Ein solcher NTC-Dünnschichtthermistor ist besonders für präzise Temperaturmessungen bei hohen Temperaturen geeignet, da ein NTC-Widerstand mit steigender Temperatur sinkt.

Die NTC-Dünnschichten können in jedem der aufgeführten Verfahren mit einem CSD-Verfahren (Chemical Solution Deposition) aufgebracht werden. Abhängig von der Geometrie und der verwendeten Materialien kann dazu Spin Coating, Dip Coating oder Ink Jet Printing, was jeweils ein CSD-Verfahren darstellt, benutzt werden. Ink Jet Printing hat den Vorteil, dass die NTC-Dünnschichten modular angepasst werden können und das Verfahren variabler ist.

Alternativ können sowohl die ersten und zweiten Dünnschichtelektroden als auch die NTC-Dünnschichten in den genannten Verfahren mit einem PVD-, oder CVD-Verfahren aufgebracht werden. Somit kann gewährleistet werden, dass alle Schichten als Dünnschichten ausgebildet werden können.

Weiterführend zu den genannten Verfahrensschritten kann der NTC-Dünnschichtthermistor, in einem weiteren Verfahrensschritt, einem Sinterprozess unterzogen werden. Durch den Sinterprozess wird die NTC-Dünnschicht, die meist als funktionelle Keramik vorliegt, mechanischer belastbar und verformungsresistent. Darüber hinaus kann eine Perowskit-, oder Spinellstruktur, abhängig vom Abscheidungsverfahren, oft erst bei einem Abkühlvorgang entstehen.

Im Anschluss an die Verfahren kann der NTC-Dünnschichtthermistor vom Trägermaterials gelöst werden, oder das Trägermaterial kann mittels eines Schleifprozesses oder Ätzprozesses ausgedünnt oder komplett entfernt wird. Folglich kann bei jedem NTC-Dünnschichtthermistor abgewogen werden, ob eine geringe Dicke oder aber eine gewisse mechanische Stabilität des NTC-Dünnschichtthermistors vorrangig ist. Je nach Präferenz kann die Dicke des Trägermaterials auf ein gewünschtes Maß reduziert werden, oder der NTC-Dünnschichtthermistor kann direkt vom Trägermaterial gelöst werden.

Im Folgenden wird die Erfindung anhand von schematischen Darstellungen näher beschrieben.
Figur 1 zeigt eine schematische Querschnittsansicht eines ersten nicht unter den Schutzumfang der Ansprüche fallenden Beispiels.
Figur 2 zeigt eine schematische Querschnittansicht eines weiteren Beispiels, welches nicht unter den Schutzumfang der Ansprüche fällt.
Figur 3 zeigt eine schematische Querschnittsansicht eines dritten nicht unter den Schutzumfang der Ansprüche fallenden Beispiels.
Figur 4 zeigt eine schematische Draufsicht des dritten Beispiels.
Figur 5 zeigt eine schematische Querschnittsansicht eines Ausführungsbeispiels der vorliegenden Erfindung.
Figur 6 zeigt eine räumliche Ansicht des Ausführungsbeispiels.
Figur 7 zeigt eine räumliche Ansicht des Ausführungsbeispiels mit zusätzlichen Kontaktpads.

Gleiche Elemente, ähnliche oder augenscheinlich gleiche Elemente sind in den Figuren mit den gleichen Bezugszeichen versehen. Die Figuren und die Größenverhältnisse in den Figuren sind nicht maßstabsgetreu.

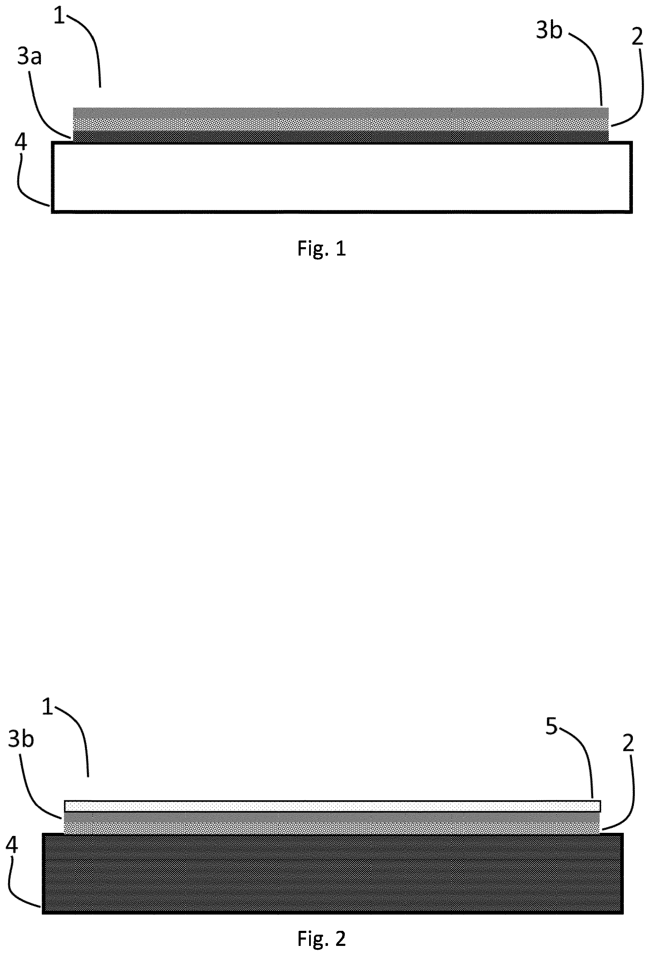

In Figur 1 wird eine Querschnittsansicht eines NTC-Dünnschichtthermistors 1 gezeigt. Auf einem Trägermaterial 4 sind eine erste Dünnschichtelektrode 3a, darüber eine NTC-Dünnschicht 2 und über dieser eine zweite Dünnschichtelektrode 3b angeordnet.

Das Trägermaterial 4 ist in diesem Ausführungsbeispiel elektrisch isolierend und eben. Eine gewisse thermische Stabilität des Trägermaterials 4 wird für mögliche thermische Prozessschritte zur Herstellung der Dünnschichten, bei denen Temperatur von über 500 °C erreicht werden können, benötigt. Passende isolierende und thermisch stabile Materialien für das Trägermaterial 4 sind poly- oder einkristalline Keramiken, passivierte Halbleiter, Polymere oder ein Glass. Bei den poly- oder einkristallinen Keramiken kann es sich beispielsweise um YSZ, AlN, ZnO, Aluminiumoxid oder Saphir, bei den passivierten Halbleitern beispielsweise um ein einkristallines Silizium mit einer SiOx Passivierung, und bei den Polymeren beispielweise um ein Polyimid handeln.

Vorzugsweise ist das Trägermaterial 4 sehr dünn, mit einer Dicke von nicht mehr als 100 µm und nicht weniger als 1 µm, es kann jedoch auch wesentlich dicker sein. Als Dicke wird hier und im Folgenden die Ausdehnung in Stapelrichtung, also senkrecht zur Oberfläche der Schichten, bezeichnet. Die erste Dünnschichtelektrode 3a, die NTC-Dünnschicht 2 und die zweite Dünnschichtelektrode 3b sind in Stapelrichtung übereinander angeordnet. Der NTC-Dünnschichtthermistor 1 kann nach der Herstellung vom Trägermaterial 4 gelöst werden oder das Trägermaterial 4 kann ausgedünnt werden. Dazu können bekannte Ätz-oder Schleifprozesse verwendet werden.

Darüber hinaus kann das Trägermaterial 4 auch funktionale Eigenschaften aufweisen und z.B. ein integrierter Schaltkreis (IC) oder ein mikroelektrisches mechanisches System (MEMS) umfassen. Auf diese Weise kann der NTC-Dünnschichtthermistor 1 mit mindestens einem anderen elektrischen Bauelement, zum Beispiel einem Drucksensor oder einem piezoelektrischer Sensor, verbunden werden und somit unterschiedliche Funktionen in einem elektrischen Bauteil zusammengefügt werden.

Die ersten und zweiten Dünnschichtelektroden 3a, 3b sind im Ausführungsbeispiel aus Figur 1 über und unter der aktiven NTC-Dünnschicht 2 angeordnet. Die Dünnschichtelektroden 3a, 3b sind vorzugsweise sehr dünn, mit einer Dicke von weniger als 10 µm, ausgeführt. Chemische und physikalische Abscheidungsprozesse für Dünnschichten, wie PVD-, CVD-, CSD- oder galvanische Verfahren, sind abhängig vom benutzten Material für das Ausbilden der Dünnschichtelektroden 3a, 3b geeignet. Die Elektroden können aus einer oder mehreren Schichten sowie aus gleichen oder unterschiedlichen Materialien aufgebaut sein. Unterschiedliche Elektroden und Elektrodenschichten können, müssen aber nicht aus demselben Material bestehen. Geeignete leitende Materialien für die Elektroden sind Metalle, Legierungen, intermetallische Verbindungen oder leitende Keramiken. Bei den Metallen kann es sich beispielsweise um Cu, Ni, Ag, Au, Pt, Mo oder Wo handeln. Bei den Legierungen kann es sich etwa um Cr/Ni/Ag oder Cr/Au handeln. Bei den intermetallischen Verbindungen kann es sich um Titan-, Nickel- oder Molybdänsilicide handeln. Bei den leitenden Keramiken kann es sich beispielsweise um LNO oder ITO handeln.

Die NTC-Dünnschicht 2 ist dünner als 3 µm, vorzugsweise sogar dünner als 1 µm, und wird über einen oder mehrere Beschichtungs- sowie thermischen Prozessschritten aufgebracht. Ein geeignetes Beschichtungsverfahren für NTC-Dünnschichten 2 ist ein CSD-Verfahren bei dem die Schicht beispielsweise über Spin Coating, Dip Coating, Spray Coating oder Ink Jet Printing aufgetragen wird. Eine Abscheidung der NTC-Dünnschicht 2 über ein PVD-Verfahren ist ebenfalls möglich. Die NTC Dünnschicht 2 besteht aus einer ein- oder mehrphasigen funktionellen Keramik, die eine Spinell- oder Perowskitstruktur aufweist. Geeignete Elemente für eine NTC-Dünnschicht 2 mit Spinellstruktur sind Ni, Mn, Co, Fe, Cu und Zr. Beispielsweise kann 80 at% Mn mit 20 at% Ni ein geeignetes Mischverhältnis für eine funktionelle Keramik mit Spinellstruktur sein, die als NTC-Dünnschicht 2 verwendet wird. Eine Perowskitstruktur kann mit den Elementen Y, Cr, Ca, Al und/oder Mn realisiert werden.

Figur 2 zeigt ein zweites Ausführungsbeispiel der Erfindung, welches dem Beispiel aus Figur 1 ähnelt. Auch in diesem Beispiel sind drei Schichten auf einem Trägermaterial 4 übereinander aufgetragen. Im Gegensatz zum ersten Beispiel ist das Trägermaterial 4 hier jedoch auch gleichzeitig eine erste Elektrode bzw. Bottom-Elektrode. Auf dem Trägermaterial 4, das auch als erste Elektrode fungiert, sind übereinander eine NTC-Dünnschicht 2, eine zweite Dünnschichtelektrode 3b sowie eine Schutzschicht 5, aufgetragen.

Das Trägermaterial 4 ist in diesem Ausführungsbeispiel ausreichend leitend um als Bottom-Elektrode zu dienen. Geeignete Materialien sind Metalle, Legierungen oder hochdotierte Halbleiter. Mit leitenden Material beschichtete Isolatoren können ebenfalls verwendet werden. Insbesondere kann das Trägermaterial 4 auch als eine leitende Keramik vorliegen. Somit ist es besonders einfach den NTC-Dünnschichtthermistor 1 mit einem anderen elektrischen Bauelement, welches selbst eine leitende Keramik aufweist, zu verbinden. Auf diese Weise können zwei oder mehr Funktionen von unterschiedlichen Bauelementen kombiniert und integrativ in einem Bauteil verschmolzen werden.

Die Schutzschicht 5 ist eine elektrische passive Schicht, die den NTC-Dünnschichtthermistor 1 vor mechanischen, chemischen und anderen Umwelteinflüssen schützt. Bei einer einseitigen Beschichtung des NTC-Dünnschichtthermistors 1 mit einer Schutzschicht 5 kann ein Dünnschichtverfahren wie bei den anderen Dünnschichten, vor allem auch ein PVD-Verfahren, verwendet werden. Alternativ kann der NTC-Dünnschichtsensor 2 auch in einer Folie verklebt oder verschweißt werden.

Geeignete Materialien für die Schutzschicht 5 können Glas, Silikon oder andere Polymere eignen. Die Schutzschicht 5 muss nicht unbedingt, wie in Figur 2 gezeigt, einseitig auf dem NTC-Dünnschichtthermistor 1 aufgebracht werden, sondern kann den NTC-Dünnschichtthermistor 1 umschließen. Besonders vorteilhaft ist ein gesamter Einschluss des NTC-Dünnschichtthermistors 1 in einer Schutzschicht 5, falls dieser vom Trägermaterial 4 abgelöst wird oder besonders dünn gestaltet ist.

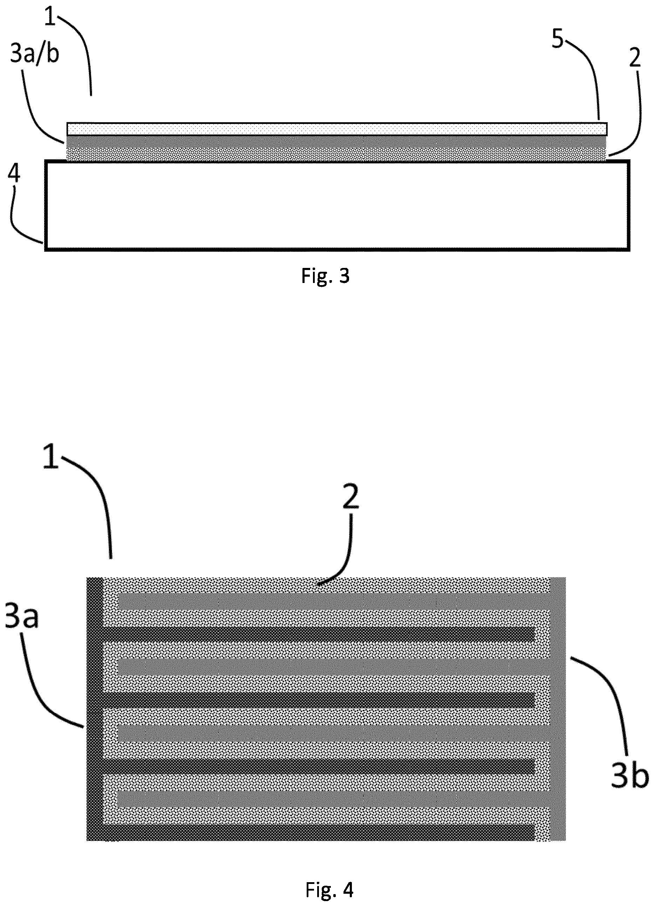

Figur 3 zeigt ein weiteres Beispiel, welches dem Beispiel aus Figur 2 ähnelt. Drei Schichten sind auf einem Trägermaterial 4 übereinander gestapelt. Im Gegensatz zum vorherigen Beispiel ist das Trägermaterial 4 hier jedoch nicht leitend und wirkt daher nicht als Elektrode. Auf dem Trägermaterial 4 wurde eine NTC-Dünnschicht 2 aufgetragen. Auf die NTC-Dünnschicht 2 wurden direkt beide, die ersten und zweiten, Dünnschichtelektroden 3a, 3b aufgetragen, wobei in Figur 3 nur eine Dünnschichtelektrode 3a, 3b sichtbar ist. Die Dünnschichtelektroden 3a, 3b und die NTC-Dünnschicht 2 wurden hier ebenfalls durch eine Schutzschicht 5 gegen Umwelteinflüsse gesichert.

In Figur 4 wird eine Draufsicht auf einen NTC-Dünnschichtthermistor 1 gezeigt, bei dem wie im Ausführungsbeispiel aus Figur 3 beide Elektroden auf der NTC-Dünnschicht 2 angeordnet sind. Die ersten und zweiten Dünnschichtelektroden 3a, 3b sind in einer interdigitalen Kammstruktur angeordnet. Da die Dünnschichtelektroden 3a, 3b einen äquidistanten Abstand voneinander haben, wirkt bei einer angelegten Messspannung das gleiche elektrische Feld zwischen den Dünnschichtelektroden 3a, 3b. Daher weist der Messstrom eines NTC-Dünnschichtthermistors 1, der mit Dünnschichtelektroden 3a, 3b versehen ist, die eine interdigitale Kammstruktur aufweisen, eine vorteilhafte Linearität bezüglich einer angelegten Messspannung auf. Die Elektrodenstruktur kann entweder direkt beim Abscheiden der Dünnschichtelektroden 3a, 3b auf die NTC-Dünnschicht 2 mittels einer Schattenmaske oder über ein lithographisches Verfahren im Nachhinein realisiert werden. Abhängig vom gewünschten Widerstand und der Gestaltung des NTC-Dünnschichtthermistors 1 kann eine andere Anordnung der Dünnschichtelektroden 3a, 3b ansprechender sein.

Dank der Anordnung der ersten und zweiten Dünnschichtelektroden 3a, 3b auf einer Oberfläche der NTC-Dünnschicht 2 kann der NTC-Dünnschichtthermistor 1 mit einer Dicke von weniger als 50 µm besonders dünn gestaltet werden. Darüber hinaus kann die Anforderung an die Qualität der NTC-Dünnschicht 2 geringer sein, da der Messstrom relativ weit entlang der Oberfläche fliest und vertikale Defekte der NTC-Dünnschicht 2 wenig Einfluss auf diesen haben.

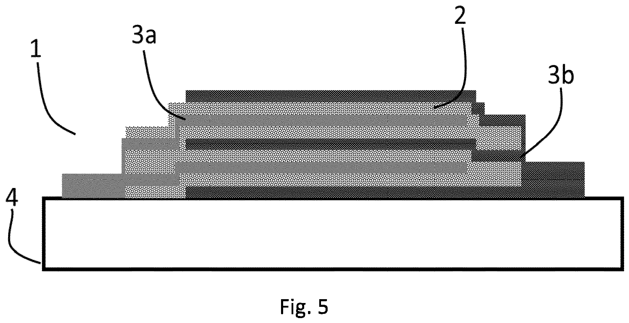

In Figur 5 wird eine Querschnittsansicht einer Ausführungsform gemäß der vorliegenden Erfindung gezeigt. Dabei ist der NTC-Dünnschichtthermistor 1 ein Mehrschichtbauteil. Die ersten und zweiten Dünnschichtelektroden 3a, 3b sind alternierend auf dem nicht leitenden Trägermaterial 4 aufgebracht worden, wobei immer eine NTC-Dünnschicht 2 zwischen ihnen liegt. In den Randbereichen von einer ersten und zweiten Seite hängt jeweils eine Art der Dünnschichtelektroden 3a, 3b gegenüber der NTC-Dünnschicht 2 über, wogegen die andere Art gegenüber der NTC-Dünnschicht 2 verkürzt ist. Auf diese Weise können die Dünnschichtelektroden 3a, 3b einer Art einfach miteinander verbunden und gleichzeitig einen Kurzschluss mit der Gegendünnschichtelektrode verhindert werden. Durch das formangepasste Aufliegen der jeweiligen Dünnschichtelektroden 3a, 3b aufeinander, wird über die gesteigerte Kontaktoberfläche zwischen den benachbarten Dünnschichtelektroden die elektrische Kontaktierung verbessert und die Gefahr, dass eine der Dünnschichtelektroden elektrisch nicht kontaktiert wird, gemindert.

Es kann vorteilhaft sein die Innenelektroden des mehrschichtigen NTC-Dünnschichtthermistors 1 aus einer leitenden Keramik zu bilden, da diese gut an den funktionellen keramischen NTC-Dünnschichten 2 haftet und das gesamte aktive Element des NTC-Dünnschichtthermistors 1 vollkeramisch ausgebildet ist. In diesem Fall kann es trotzdem vorteilhaft sein eine unterste und eine oberste Elektrode des Mehrschichtaufbaus aus einem Metall oder einem anderen leitenden Materialien zu bilden.

Auf Grund des Schichtaufbaus und den Überhängen bildet sich auf einer ersten und zweiten Seite des NTC-Dünnschichtthermistors 1 eine Treppenform, die das Bauteil in der Dickenrichtung verjüngt. Die Dünnschichtelektroden 3a, 3b, in können in dem Bereich in dem sie gegenüber der NTC-Dünnschicht 2 überhängen, gegenüber der darunter liegenden Dünnschichtelektrode 3a, 3b verkürzt sein. Somit kann Kontaktoberfläche der Dünnschichtelektroden 3a, 3b vergrößert und der Kontaktwiderstand des NTC-Dünnschichtthermistors 1 verringert werden. Ein NTC-Dünnschichtthermistor 1 mit geringen Kontaktwiderstand ist speziell für präzise Messungen in hohen Temperaturbereichen geeignet, da ein NTC-Widerstand mit steigender Temperatur sinkt.

Der Bereich in der Mitte, in der alle drei Schichtarten überlappen, ist der aktive Messbereich des NTC-Dünnschichtthermistors 1. Die Bereiche in denen nur einer Art Dünnschichtelektrode sich mit der NTC-Dünnschicht 2 abwechselt sind messtechnisch irrelevant und sollten möglichst klein gehalten werden. An den Rändern, an denen die Dünnschichtelektroden 3a, 3b zusammengeführt werden, können die Elektroden kontaktiert werden.

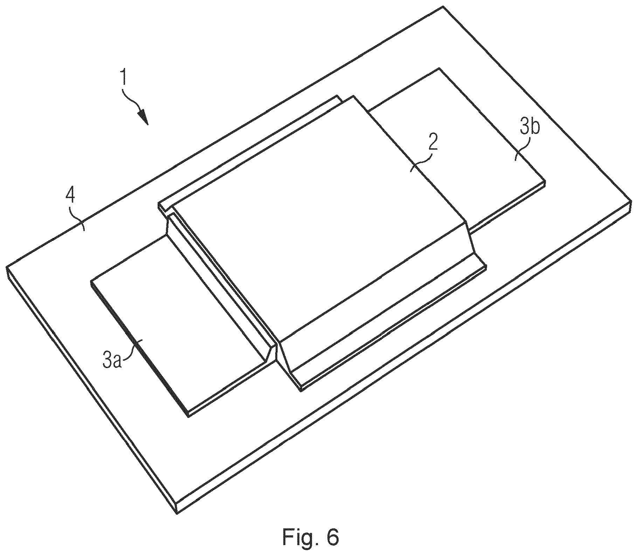

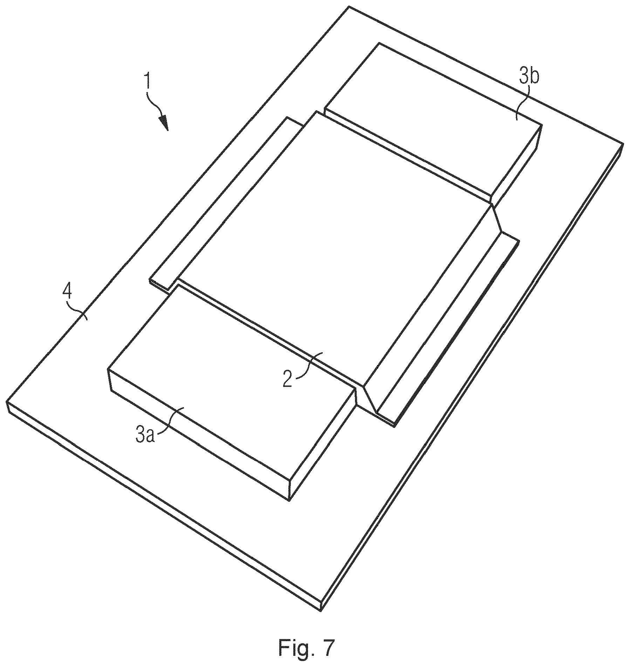

Figur 6 zeigt eine räumliche Darstellung eines NTC-Dünnschichtthermistors 1, der ebenfalls einen mehrschichtigen Aufbau wie der NTC-Dünnschichtthermistor 1 aus Figur 5 aufweist und auf einem Trägermaterial 4 angeordnet ist. In diesem Ausführungsbeispiel hängen die NTC-Dünnschichten 2 auf einer dritten und vierten Seite, die senkrecht zur ersten und zweiten Seite sind, gegenüber den Dünnschichtelektroden 3a, 3b über. Das überhängende NTC-Material bildet abfallende Schrägen auf der dritten und vierten Seite in Figur 6. Der Überhang der NTC-Dünnschichten 2 sorgt dafür, dass die ersten und zweiten Dünnschichtelektroden 3a, 3b auch in den Randbereichen voneinander abgekapselt sind. Auf diese Weise wird sichergestellt, dass trotz des geringen Abstands zueinander erste und zweite Dünnschichtelektroden 3a, 3b nicht miteinander kurzschließen. Da die Dünnschichtelektroden 3a, 3b an den Rändern, obwohl mehrere Schichten überlagern, immer noch sehr dünn sind, ist es ratsam die Elektroden mit einer metallischen Paste, Kontaktpads, einem Siebdruckverfahren, einem Dünnschichtverfahren oder einem galvanischen Prozess zu verstärken. In der Figur 7 wird der NTC-Dünnschichtthermistor 1 aus Figur 6 mit zusätzlichen Kontaktpads gezeigt.

Der beschrieben Schichtaufbau hat zur Folge, dass der Messstrom in diesen Ausführungsbeispielen, im Gegensatz zu dem Ausführungsbeispiel, bei dem die Dünnschichtelektroden 3a, 3b auf einer Oberfläche der NTC-Dünnschicht 2 angeordnet sind, vertikal durch die NTC-Schicht fließt. Einerseits wird dadurch der Anspruch an die Qualität der NTC-Dünnschicht 2 erhöht, da Defekte eine größere Auswirkung auf den Messstrom haben, andererseits ist die Messgenauigkeit nicht von der Größe der Oberfläche der NTC-Dünnschicht 2 abhängig. Daher lassen sich mit dem Schichtaufbau NTC-Dünnschichtthermistoren 1 realisieren, die mit einer Grundfläche, deren Seitenlänge zwischen 80 und 120 µm liegen, und einer Dicke von weniger als 100 µm nicht nur ausgesprochen dünn sind, sondern auch eine kleine Oberfläche aufweisen.

Sensoren, die eine so kleine Oberfläche besitzen, können beispielsweise in ortauflösenden Messungen eingesetzt werden. Werden mehrere NTC-Dünnschichtthermistoren 1 nach einem der Ausführungsbeispiele in einer Matrix angeordnet, kann man mit dieser Anordnung eine ortsaufgelöste Temperaturmessung vorgenommen werden. Darüber hinaus sind elektrische Bauteile mit einer so geringen Größe prädestiniert dafür, mit anderen elektrischen Bauteilen verbunden oder in diese integriert zu werden. Insbesondere können die NTC-Dünnschichtthermistoren 1 nach der vorliegenden Erfindung auch in Leiterplatten, die häufig nur noch eine Dicke von einigen 100 µm besitzen, integriert werden und müssen nicht auf diese montiert werden.

### Bezugszeichenliste

- 1: NTC-Dünnschichtthermistor
- 2: NTC-Dünnschicht
- 3a: erste Dünnschichtelektrode
- 3b: zweite Dünnschichtelektrode
- 4: Trägermaterial
- 5: Schutzschicht

## Patentansprüche

1. Ein NTC-Dünnschichtthermistor (1) aufweisend mindestens eine erste Dünnschichtelektrode (3a), mindestens eine NTC-Dünnschicht (2), die eine ein- oder polykristalline funktionelle Keramik mit einer Spinellstruktur oder eine Perowskitstruktur aufweist und mindestens eine zweite Dünnschichtelektrode (3b),
**dadurch gekennzeichnet, dass**
der NTC-Dünnschichtthermistor (1) mehrere erste und zweite Dünnschichtelektroden (3a, 3b) aufweist, und wobei jeweils eine NTC-Dünnschicht (2) zwischen den ersten Dünnschichtelektroden (3a) und den zweiten Dünnschichtelektroden (3b) angeordnet ist,
dass die ersten Dünnschichtelektroden (3a) auf einer ersten Seite des NTC-Dünnschichtthermistors (1) gegenüber der NTC-Dünnschicht (2) überhängen und die zweiten Dünnschichtelektroden (3b) auf der ersten Seite gegenüber der NTC-Dünnschicht (2) verkürzt sind und
dass die zweiten Dünnschichtelektroden (3b) auf einer zweiten Seite des NTC-Dünnschichtthermistors (1), die der ersten Seite gegenüberliegt, gegenüber der NTC-Dünnschicht (2) überhängen und die ersten Dünnschichtelektroden (3a) auf der zweiten Seite gegenüber der NTC-Dünnschicht (2) verkürzt sind.

2. Ein NTC-Dünnschichtthermistor (1) nach Anspruch 1, wobei die NTC-Dünnschicht (2) zumindest eines der Elemente Mn, Ni, Zn, Fe, Co, Cu, Zr, Y, Cr, Ca oder Al aufweist.

3. Ein NTC-Dünnschichtthermistor (1) nach Anspruch 1 oder 2,
wobei die Dünnschichtelektroden (3a, 3b) aus einer leitenden Keramik bestehen.

4. Ein NTC-Dünnschichtthermistor (1) nach Anspruch 1 oder 2,
wobei die Dünnschichtelektroden (3a, 3b) aus einer oder mehreren Lagen von Metallen wie Cu, Pt, Cr, Ni, Ag, Pd, Au, Ti, einer Mischung oder einer Legierung dieser Elemente besteht.

5. Ein NTC-Dünnschichtthermistor (1) nach einem der Ansprüche 1 bis 4, wobei die ersten und zweiten Dünnschichtelektroden (3a, 3b) in einem Bereich, in dem sie gegenüber der NTC-Dünnschicht (2) überhängen, auf einer jeweils darunter liegenden ersten oder zweiten Dünnschichtelektrode (3a, 3b), die gegenüber der NTC-Dünnschicht (2) überhängt, aufliegen.

6. Ein NTC-Dünnschichtthermistor (1) nach einem der Ansprüche 1 bis 5,
wobei die ersten und zweiten Dünnschichtelektroden (3a, 3b) in einem Bereich, in dem sie gegenüber der NTC-Dünnschicht (2) überhängen, kürzer sind als darunter liegenden ersten oder zweiten Dünnschichtelektroden (3a, 3b), die gegenüber der NTC-Dünnschicht (2) überhängen.

7. Ein NTC-Dünnschichtthermistor (1) nach einem der Ansprüche 1 bis 6,
wobei an der ersten und zweiten Seite überstehende Teilbereiche der ersten und zweiten Dünnschichtelektrode (3a, 3b) mit einer metallisierten Paste oder einem anderem leitenden Medium verstärkt sind.

8. Ein NTC-Dünnschichtthermistor (1) nach einem der Ansprüche 1 bis 7,
wobei die NTC-Dünnschichten (2) auf einer dritten und vierten Seite, die senkrecht zur ersten und zweiten Seite sind und sich gegenüberliegen, gegenüber den Dünnschichtelektroden (3a, 3b) überhängen.

9. Ein NTC-Dünnschichtthermistor (1) nach dem vorherigen Anspruch,
wobei die NTC-Dünnschichten (2) in einem Bereich, in dem sie gegenüber den Dünnschichtelektroden (3a, 3b) überhängen, kürzer sind als darunter liegende NTC-Dünnschichten (2).

10. Ein NTC-Dünnschichtthermistor (1) nach einem der vorherigen Ansprüche,
wobei der NTC-Dünnschichtthermistor (1) auf einem Trägermaterial (4) angeordnet ist.

11. Ein NTC-Dünnschichtthermistor (1) nach dem vorherigen Anspruch,
wobei das Trägermaterial (4) als eine erste Elektrode ausgebildet ist.

12. Ein NTC-Dünnschichtthermistor (1) nach Anspruch 11, wobei in dem Trägermaterial (4) ein Schaltkreis oder ein Mikroelektronisches Mechanisches System integriert ist, oder das Trägermaterial (4) ein Bestandteil eines elektronischen Bauteils ist.

13. Ein NTC-Dünnschichtthermistor (1) nach einem der vorherigen Ansprüche,
wobei die NTC-Dünnschicht (2) dünner als 3 µm ist.

14. Ein NTC-Dünnschichtthermistor (1) nach einem der vorherigen Ansprüche,
wobei die Dünnschichtelektroden (3a, 3b) dünner als 10 µm sind.

15. Ein NTC-Dünnschichtthermistor (1) nach einem der vorherigen Ansprüche,
wobei der gesamte NTC-Dünnschichtthermistor (1) dünner als 100 µm ist.

16. Ein NTC-Dünnschichtthermistor (1) nach einem der vorherigen Ansprüche,
wobei der NTC-Dünnschichtthermistor (1) dafür geeignet ist in ein Substrat oder eine Leiterplatte integriert zu werden.

17. Eine Anordnung, aufweisend:
- eine Leiterplatte,
- einen NTC-Dünnschichtthermistor (1) nach einem der vorherigen Ansprüche,
wobei der NTC-Dünnschichtthermistor (1) in der Leiterplatte integriert ist.

18. Eine Anordnung, aufweisend:
- mehrere NTC-Dünnschichtthermistoren (1) nach einem der Ansprüche 1 bis 17,
wobei die NTC-Dünnschichtthermistoren (1) in einer Matrix angeordnet sind.

19. Ein Verfahren zur Herstellung eines NTC-Dünnschichtthermistors (1) mit folgenden Schritten:
a) Bereitstellen eines nicht leitenden Trägermaterials (4);
b) Aufbringen von mindestens einer ersten Dünnschichtelektrode (3a);
c) Aufbringen von mindestens einer NTC-Dünnschicht (2), die eine ein- oder polykristalline funktionelle Keramik mit einer Spinellstruktur oder eine Perowskitstruktur aufweist;
d) Aufbringen von mindestens einer zweiten Dünnschichtelektrode (3b),
**dadurch gekennzeichnet, dass**
der NTC-Dünnschichtthermistor (1) mehrere erste und zweite Dünnschichtelektroden (3a, 3b) aufweist, und wobei jeweils eine NTC-Dünnschicht (2) zwischen den ersten Dünnschichtelektroden (3a) und den zweiten Dünnschichtelektroden (3b) angeordnet ist,
dass die ersten Dünnschichtelektroden (3a) auf einer ersten Seite des NTC-Dünnschichtthermistors (1) gegenüber der NTC-Dünnschicht (2) überhängen und die zweiten Dünnschichtelektroden (3b) auf der ersten Seite gegenüber der NTC-Dünnschicht (2) verkürzt sind und
dass die zweiten Dünnschichtelektroden (3b) auf einer zweiten Seite des NTC-Dünnschichtthermistors (1), die der ersten Seite gegenüberliegt, gegenüber der NTC-Dünnschicht (2) überhängen und die ersten Dünnschichtelektroden (3a) auf der zweiten Seite gegenüber der NTC-Dünnschicht (2) verkürzt sind.

20. Ein Verfahren nach dem vorherigen Anspruch,
wobei im Schritt b) die ersten Dünnschichtelektroden (3a) auch in einen ersten Bereich aufgebracht werden, in dem keine NTC-Dünnschicht (2) darunter liegt, und
wobei im Schritt d) die zweiten Dünnschichtelektroden (3b) auch in einen zweiten Bereich aufgebracht werden, in dem keine NTC-Dünnschicht (2) darunter liegt, und
wobei der erste und zweite Bereich nicht miteinander überlappen, und das Verfahren eine Schrittfolge enthält, in der erst eine erste Dünnschichtelektrode (3a) aufgetragen wird, darauffolgend eine NTC-Dünnschicht (2) aufgetragen wird, darauffolgend eine zweite Dünnschichtelektrode (3b) aufgetragen wird, darauffolgend wieder eine NTC-Dünnschicht (29) aufgetragen wird, und im Anschluss wieder eine erste Dünnschichtelektrode (3a) aufgetragen wird.

21. Ein Verfahren nach einem der Ansprüche 19 oder 20,
wobei die NTC Dünnschichten (2) mit einem Chemical Solution Deposition-Verfahren (CSD-Verfahren) aufgebracht werden.

22. Ein Verfahren nach einem der Ansprüche 19 oder 20, wobei die ersten und zweiten Dünnschichtelektroden (3a, 3b) und NTC-Dünnschichten (2) mit einem PVD-, oder CVD-Verfahren aufgebracht werden.

23. Ein Verfahren nach einem der Ansprüche 19 bis 22, wobei in einem weiteren Verfahrensschritt der NTC-Dünnschichtthermistor (1) einem Sinterprozess unterzogen wird.

24. Ein Verfahren nach einem der Ansprüche 19 bis 23, wobei in einem weiteren Verfahrensschritt der Schichtstapel, bestehend aus ersten und zweiten Dünnschichtelektroden (3a, 3b) und NTC-Dünnschichten (2), vom Trägermaterial (4) gelöst wird, oder das Trägermaterial (4) mittels einem Schleifprozess oder Ätzprozess ausgedünnt oder komplett entfernt wird.

## Claims

1. NTC thin film thermistor (1) having at least one first thin film electrode (3a), at least one NTC thin film (2), which has a monocrystalline or polycrystalline functional ceramic with a spinel structure or a perovskite structure, and at least one second thin film electrode (3b),
**characterized in that**
the NTC thin film thermistor (1) has a plurality of first and second thin film electrodes (3a, 3b), and wherein each NTC thin film (2) is arranged between the first thin film electrodes (3a) and the second thin film electrodes (3b),
the first thin film electrodes (3a) on a first side of the NTC thin film thermistor (1) overhang with respect to the NTC thin film (2) and the second thin film electrodes (3b) on the first side are shortened with respect to the NTC thin film (2) and
the second thin film electrodes (3b) on a second side of the NTC thin film thermistor (1), which is opposite the first side, overhang with respect to the NTC thin film (2) and the first thin film electrodes (3a) on the second side are shortened with respect to the NTC thin film (2).

2. NTC thin film thermistor (1) according to Claim 1, wherein the NTC thin film (2) comprises at least one of the elements Mn, Ni, Zn, Fe, Co, Cu, Zr, Y, Cr, Ca or Al.

3. NTC thin film thermistor (1) according to Claim 1 or 2, wherein the thin film electrodes (3a, 3b) consist of a conductive ceramic.

4. NTC thin film thermistor (1) according to Claim 1 or 2, wherein the thin film electrodes (3a, 3b) consist of one or more layers of metal such as Cu, Pt, Cr, Ni, Ag, Pd, Au, Ti, a mixture or an alloy of these elements.

5. NTC thin film thermistor (1) according to one of Claims 1 to 4, wherein the first and second thin film electrodes (3a, 3b), in a region in which they overhang with respect to the NTC thin film (2), lie on a respective first or second thin film electrode (3a, 3b) below which overhangs with respect to the NTC thin film (2).

6. NTC thin film thermistor (1) according to one of Claims 1 to 5, wherein the first and second thin film electrodes (3a, 3b), in a region in which they overhang with respect to the NTC thin film (2), are shorter than first or second thin film electrodes (3a, 3b) below which overhang with respect to the NTC thin film (2).

7. NTC thin film thermistor (1) according to one of Claims 1 to 6, wherein subregions of the first and second thin film electrode (3a, 3b) that project at the first and second side are reinforced with a metallized paste or another conductive medium.

8. NTC thin film thermistor (1) according to one of Claims 1 to 7, wherein the NTC thin films (2) overhang on a third and fourth side, which are perpendicular to the first and second side and are opposite one another, with respect to the thin film electrodes (3a, 3b).

9. NTC thin film thermistor (1) according to the preceding claim, wherein the NTC thin films (2) are shorter in a region in which they overhang with respect to the thin film electrodes (3a, 3b) than NTC thin films (2) below.

10. NTC thin film thermistor (1) according to one of the preceding claims, wherein the NTC thin film thermistor (1) is arranged on a carrier material (4).

11. NTC thin film thermistor (1) according to the preceding claim, wherein the carrier material (4) is in the form of a first electrode.

12. NTC thin film thermistor (1) according to Claim 11, wherein a circuit or a microelectronic mechanical system is integrated in the carrier material (4), or the carrier material (4) is a constituent part of an electronic component.

13. NTC thin film thermistor (1) according to one of the preceding claims, wherein the NTC thin film (2) is thinner than 3 µm.

14. NTC thin film thermistor (1) according to one of the preceding claims, wherein the thin film electrodes (3a, 3b) are thinner than 10 µm.

15. NTC thin film thermistor (1) according to one of the preceding claims, wherein the entire NTC thin film thermistor (1) is thinner than 100 µm.

16. NTC thin film thermistor (1) according to one of the preceding claims, wherein the NTC thin film thermistor (1) is suitable for integration into a substrate or a printed circuit board.

17. Arrangement, comprising:
- a printed circuit board,
- an NTC thin film thermistor (1) according to one of the preceding claims,
wherein the NTC thin film thermistor (1) is integrated in the printed circuit board.

18. Arrangement, comprising:
- a plurality of NTC thin film thermistors (1) according to one of Claims 1 to 17,
wherein the NTC thin film thermistors (1) are arranged in a matrix.

19. Method for producing an NTC thin film thermistor (1), comprising the following steps:
a) providing a nonconductive carrier material (4);
b) applying at least one first thin film electrode (3a);
c) applying at least one NTC thin film (2), which comprises a monocrystalline or polycrystalline functional ceramic having a spinal structural or a perovskite structure;
d) applying at least one second thin film electrode (3b), **characterized in that**
the NTC thin film thermistor (1) has a plurality of first and second thin film electrodes (3a, 3b), and wherein each NTC thin film (2) is arranged between the first thin film electrodes (3a) and the second thin film electrodes (3b),
the first thin film electrodes (3a) on a first side of the NTC thin film thermistor (1) overhang with respect to the NTC thin film (2) and the second thin film electrodes (3b) on the first side are shortened with respect to the NTC thin film (2) and
the second thin film electrodes (3b) on a second side of the NTC thin film thermistor (1), which is opposite the first side, overhang with respect to the NTC thin film (2) and the first thin film electrodes (3a) on the second side are shortened with respect to the NTC thin film (2).

20. Method according to the preceding claim,
wherein, in step b), the first thin film electrodes (3a) are also applied in a first region in which there is no NTC thin film (2) below, and
wherein, in step d), the second thin film electrodes (3b) are also applied in a second region in which there is no NTC thin film (2) below, and
wherein the first and second region do not overlap with one another, and the method contains a sequence of steps in which a first thin film electrode (3a) is applied first, then an NTC thin film (2) is applied, then a second thin film electrode (3b) is applied, then another NTC thin film (29) is applied, and finally another first thin film electrode (3a) is applied.

21. Method according to either of Claims 19 and 20, wherein the NTC thin films (2) are applied using a chemical solution deposition (CSD) method.

22. Method according to either of Claims 19 and 20, wherein the first and second thin film electrodes (3a, 3b) are applied using a PVD or CVD method.

23. Method according to one of Claims 19 to 22, wherein, in another method step, the NTC thin film thermistor (1) is subjected to a sintering process.

24. Method according to one of Claims 19 to 23, wherein, in another method step, the layer stack, consisting of first and second thin film electrodes (3a, 3b) and NTC thin films (2), is detached from the carrier material (4), or the carrier material (4) is thinned out or completely removed by means of a grinding process or etching process.

## Revendications

1. Thermistance NTC à couche mince (1) présentant au moins une première électrode à couche mince (3a), au moins une couche mince NTC (2) qui présente une céramique fonctionnelle monocristalline ou polycristalline pourvue d'une structure de spinelle ou d'une structure pérovskite et au moins une deuxième électrode à couche mince (3b),
**caractérisée**
**en ce que** la thermistance NTC à couche mince (1) présente plusieurs premières et deuxièmes électrodes à couche mince (3a, 3b), et dans laquelle respectivement une couche mince NTC (2) est disposée entre les premières électrodes à couche mince (3a) et les deuxièmes électrodes à couche mince (3b),
**en ce que** les premières électrodes à couche mince (3a) sur une première face de la thermistance NTC à couche mince (1) débordent par rapport à la couche mince NTC (2), et les deuxièmes électrodes à couche mince (3b) sur la première face sont tronquées par rapport à la couche mince NTC (2), et
**en ce que** les deuxièmes électrodes à couche mince (3b) sur une deuxième face de la thermistance NTC à couche mince (1), qui est opposée à la première face, débordent par rapport à la couche mince NTC (2), et les premières électrodes à couche mince (3a) sur la deuxième face sont tronquées par rapport à la couche mince NTC (2).

2. Thermistance NTC à couche mince (1) selon la revendication 1, dans laquelle la couche mince NTC (2) présente au moins l'un des éléments Mn, Ni, Zn, Fe, Co, Cu, Zr, Y, Cr, Ca ou Al.

3. Thermistance NTC à couche mince (1) selon la revendication 1 ou 2, dans laquelle les électrodes à couche mince (3a, 3b) sont composées d'une céramique conductrice.

4. Thermistance NTC à couche mince (1) selon la revendication 1 ou 2, dans laquelle les électrodes à couche mince (3a, 3b) sont composées d'une ou de plusieurs couches de métaux, tels que Cu, Pt, Cr, Ni, Ag, Pd, Au, Ti, d'un mélange ou d'un alliage de ces éléments.

5. Thermistance NTC à couche mince (1) selon l'une quelconque des revendications 1 à 4, dans laquelle les premières et deuxièmes électrodes à couche mince (3a, 3b), dans une zone où elles débordent par rapport à la couche mince NTC (2), reposent sur une première ou deuxième électrode à couche mince (3a, 3b) respectivement sous-jacente qui déborde par rapport à la couche mince NTC (2).

6. Thermistance NTC à couche mince (1) selon l'une quelconque des revendications 1 à 5, dans laquelle les premières et deuxièmes électrodes à couche mince (3a, 3b), dans une zone dans laquelle elles débordent par rapport à la couche mince NTC (2), sont plus courtes que les premières ou deuxièmes électrodes à couche mince (3a, 3b) sous-jacentes qui débordent par rapport à la couche mince NTC (2).

7. Thermistance NTC à couche mince (1) selon l'une quelconque des revendications 1 à 6, dans laquelle des zones partielles faisant saillie sur la première et la deuxième face de la première et de la deuxième électrode à couche mince (3a, 3b) sont renforcées par une pâte métallisée ou un autre milieu conducteur.

8. Thermistance NTC à couche mince (1) selon l'une quelconque des revendications 1 à 7, dans laquelle les couches minces NTC (2) débordent par rapport aux électrodes à couche mince (3a, 3b) sur une troisième et une quatrième face qui sont perpendiculaires à la première et à la deuxième face et sont opposées l'une à l'autre.

9. Thermistance NTC à couche mince (1) selon la revendication précédente, dans laquelle, dans une zone dans laquelle elles débordent par rapport aux électrodes à couche mince (3a, 3b), les couches minces NTC (2) sont plus courtes que des couches minces NTC sous-jacentes (2).

10. Thermistance NTC à couche mince (1) selon l'une quelconque des revendications, dans laquelle la thermistance NTC à couche mince (1) est disposée sur un matériau support (4).

11. Thermistance NTC à couche mince (1) selon la revendication précédente, dans laquelle le matériau support (4) est réalisé sous la forme d'une première électrode.

12. Thermistance NTC à couche mince (1) selon la revendication 11, dans laquelle un circuit ou un microsystème électromécanique est intégré dans le matériau support (4), ou le matériau support (4) fait partie d'un composant électronique.

13. Thermistance NTC à couche mince (1) selon l'une quelconque des revendications précédentes, dans laquelle la couche mince NTC (2) est plus mince que 3 µm.

14. Thermistance NTC à couche mince (1) selon l'une quelconque des revendications précédentes, dans laquelle les électrodes à couche mince (3a, 3b) sont plus minces que 10 µm.

15. Thermistance NTC à couche mince (1) selon l'une quelconque des revendications précédentes, dans laquelle toute la thermistance NTC à couche mince (1) est plus mince que 100 µm.

16. Thermistance NTC à couche mince (1) selon l'une quelconque des revendications précédentes, dans laquelle la thermistance NTC à couche mince (1) est adaptée pour être intégrée dans un substrat ou une carte de circuits intégrés.

17. Agencement, présentant :
- une carte de circuits intégrés,
- une thermistance NTC à couche mince (1) selon l'une quelconque des revendications précédentes,
dans lequel la thermistance NTC à couche mince (1) est intégrée dans la carte de circuits intégrés.

18. Agencement, présentant :
- plusieurs thermistances NTC à couche mince (1) selon l'une quelconque des revendications 1 à 17,
dans lequel les thermistances NTC à couche mince (1) sont agencées en matrice.

19. Procédé de fabrication d'une thermistance NTC à couche mince (1), comprenant les étapes suivantes consistant à :
a) fournir un matériau support (4) non conducteur ;
b) appliquer au moins une première électrode à couche mince (3a) ;
c) appliquer au moins une couche mince NTC (2) qui présente une céramique fonctionnelle monocristalline ou polycristalline ayant une structure de spinelle ou une structure pérovskite ;
d) appliquer au moins une deuxième électrode à couche mince (3b),
**caractérisé**
**en ce que** la thermistance NTC à couche mince (1) présente plusieurs premières et deuxièmes électrodes à couche mince (3a, 3b), et dans lequel respectivement une couche mince NTC (2) est disposée entre les premières électrodes à couche mince (3a) et les deuxièmes électrodes à couche mince (3b),
**en ce que** les premières électrodes à couche mince (3a) sur une première face de la thermistance NTC à couche mince (1) débordent par rapport à la couche mince NTC (2), et les deuxièmes électrodes à couche mince (3b) sur la première face sont tronquées par rapport à la couche mince NTC (2), et
**en ce que** les deuxièmes électrodes à couche mince (3b) sur une deuxième face de la thermistance NTC à couche mince (1), qui est opposée à la première face, débordent par rapport à la couche mince NTC (2), et les premières électrodes à couche mince (3a) sur la deuxième face sont tronquées par rapport à la couche mince NTC (2).

20. Procédé selon la revendication précédente,
dans lequel à l'étape b) les premières électrodes à couche mince (3a) sont également appliquées dans une première zone dans laquelle aucune couche mince NTC (2) n'est sous-jacente, et
dans lequel à l'étape d) les deuxièmes électrodes à couche mince (3b) sont également appliquées dans une deuxième zone dans laquelle aucune couche mince NTC (2) n'est sous-jacente, et
dans lequel la première et la deuxième zone ne se chevauchent pas, et le procédé comprend une séquence d'étapes dans laquelle d'abord une première électrode à couche mince (3a) est appliquée, ensuite une couche mince NTC (2) est appliquée, ensuite une deuxième électrode à couche mince (3b) est appliquée, ensuite à nouveau une couche mince NTC (29) est appliquée, et après à nouveau une première électrode à couche mince (3a) est appliquée.

21. Procédé selon l'une quelconque des revendications 19 ou 20, dans lequel les couches minces NTC (2) sont appliquées à l'aide d'un procédé de dépôt de solution chimique (CSD).

22. Procédé selon l'une quelconque des revendications 19 ou 20, dans lequel les premières et deuxièmes électrodes à couche mince (3a, 3b) et les couches minces NTC (2) sont appliquées à l'aide d'un procédé PVD ou CVD.

23. Procédé selon l'une quelconque des revendications 19 à 22, dans lequel dans une étape de procédé supplémentaire, la thermistance NTC à couche mince (1) est soumise à un processus de frittage.

24. Procédé selon l'une quelconque des revendications 19 à 23, dans lequel dans une étape de procédé supplémentaire, l'empilement de couches composé des premières et deuxièmes électrodes à couche mince (3a, 3b) et des couches minces NTC (2) est détaché du matériau support (4), ou le matériau support (4) est raréfié ou entièrement retiré au moyen d'un processus de meulage ou d'un processus de gravure.
